# EUROPEAN PATENT APPLICATION

(11) **EP 4 553 877 A1**
(43) Date of publication of application: **14.05.2025**
(21) Application number: 23209563.8
(22) Date of filing: 13.11.2023
(51) Int. Cl.: H01H 21/16, H01H 85/00, G01R 31/327

(54) **LOAD-BREAK SWITCHING DEVICE, SWITCHING CABINET, AUTOMATION SYSTEM AND METHOD FOR OPERATING A LOAD-BREAK SWITCHING DEVICE**

(71) Applicant: Future Systems Besitz GmbH, 96472 Rödental (DE)
(72) Inventor: FÖRST, Bernhard, 96317 Kronach (DE); HAGNER, Martin, 96482 Ahorn (DE)
(74) Representative: Bratovic, Nino Maria

(57) **Abstract**

The invention relates to a small-sized load-break switching device for a busbar system. The load-break switching device comprises fuse receiving compartments for fuses. A simple and small sized approach for detecting a failure of the fuse in the receiving compartments is provided. A failure of the fuse is indicated by a galvanic insulated signalling.

## Description

The present invention relates to a load-break switching device, in particular a load-break switching device for a busbar system. Present invention further relates to a switching cabinet arrangement and an automation system with a load-break switching device. Further, the present invention relates to a method for operating a load-break switching device.

### Background

Switching devices, in particular load-break switches, may be used in an industrial environment for switching a power supply to a load, e.g., to an electrical device. Load-break switches are designed to interrupt an electrical connection even if an electrical current is flowing through the switch. Since load-breaker switches usually are designed for a maximum switching current which can be reliably interrupted, the load-break switches may further comprise a fuse for overcurrent protection. This fuse can make sure that the maximum switching current is not exceeded. Such load-breaking switches with an additional fuse are usually referred to as switch disconnectors with fuses.

Switch disconnectors with fuses usually require large assembly space. On the other hand, minimising of the assembly space results in a more difficult access to the individual components and especially to the fuse. This makes it difficult for a user to recognise whether a fuse is correctly inserted in the switch disconnector and whether the inserted fuse still in good order.

For busbar applications, the switch disconnectors with fuses can be installed in a casing such as a control cabinet. Thus, accessibility to the v may be further restricted. Hence, automated monitoring of the fuses in such a load-break switch for busbar applications would be advantageous. In particular, there is a need for switch disconnectors with fuses which makes is possible to monitor the fuses in a simple and cost-effective way. In addition, it is desirable to provide a monitoring system for the fuses that can be further processed in an automated manner. Especially, there is a need for providing the result of such a fuse monitoring in switch disconnectors in a reliable way, e.g.by providing a decoupled monitoring signal.

### Summary

The present invention therefore takes into account the above needs and provides a load-break switch device, a method for operating a load-break switch device, a switching cabinet arrangement and an automation system with the features of the independent claims. Further advantageous embodiments are subject matter of the dependent claims.

According to a first aspect, a load-break switching device is provided. The load-break switching device comprises a first connector unit, a second connector unit, a load-break unit, at least one fuse unit and a monitoring unit. The first connector unit comprises at least one first connection terminal. In particular a separate first connection terminal may be provided for each connection to a power source or load. Accordingly, each first connection terminal is adapted to be connected to one busbar of the busbar system.

The second connector unit comprises at least one second connection terminal. In particular, the number of second connection terminals may correspond to the number of first connection terminals. Accordingly, a separate second connection terminal may be provided for each busbar of the busbar system. In particular, each second connection terminal is adapted to be connected to an electrical connection of an external electrical device.

The external electrical device may be, for example, an electrical load such as a motor or the like. The load-break unit is adapted to interrupt the electrical connections between the first connection terminals of the first connector unit and the corresponding second connection terminals of the second connector unit. In particular, the load-break unit is adapted to interrupt the electrical connection even if a current is flowing through the load-break unit.

Each of the at least one fuse unit is disposed in one of the current paths between the first connection terminal of the first connector unit and the corresponding second connection terminal of the second connector unit. Each fuse unit comprises a fuse receiving element and an electronic unit. Each fuse receiving element is adapted to receive a fuse. In particular, the fuse may be received and arranged between a first fuse connector and a second fuse connector. Each electronic unit is adapted to sense a voltage drop in a current path between the first connector unit and the second connector unit. The current path includes the fuse receiving device. In particular a voltage drop between the first fuse connector and the second fuse connector of the fuse receiving element may be sensed. Further, each electronic unit is adapted to detect an abnormal condition of the related fuse unit. In particular, an abnormal condition may be detected if the detected voltage drop exceeds a predetermined threshold value. Further, each electronic unit is adapted to provide an output signal. The provided output signal may indicate the detected abnormal condition. In particular, the output signal is provided galvanically isolated from the fuse receiving element.

The monitoring unit is adapted to receive the output signal of the at least one electronic unit. Accordingly, the monitoring unit may perform a processing in response to the received galvanically isolated output signal from the electronic unit.

According to a second aspect, a switching cabinet arrangement is provided. The switching cabinet arrangement comprises a busbar system and a load-break switching device according to the first aspect. In particular, the busbar system comprises at least one busbar electrically connected to the first connector unit of the load-break switching device.

According to a third aspect, an automation system is provided. The automation system comprises a busbar system, an electrical device and a load-break switching device, in particular a load-break switching device according to the first aspect. The busbar system is adapted to be connected to a power source. Additionally or alternatively, the load-break switching device may be connected to a power source. For example, the power source may be an inverter, e.g. an inverter of a regenerative energy system such as a photovoltaic device. The electrical device of the automation system is electrically connected to the load break switching device. In particular, the electrical device may be connected to the second connector unit of the load-break switching device.

According to a further aspect, a method for operating a load-break switching device, in particular load-break switching device according to the first aspect is provided. The method comprises a step of sensing a voltage drop in a current path between the first connector unit and the second connector unit. The current path includes the fuse receiving device. In particular, the voltage drop may be sensed between the first fuse connector and the second fuse connector of the fuse receiving device. Further, the method comprises a step of detecting an abnormal condition of the related fuse unit, in particular of the related fuse receiving device. The abnormal condition may be detected if the detected voltage drop exceeds a predetermined threshold value. The method further comprises a step of providing an output signal. The output signal may indicate the detected abnormal condition. In particular, the output signal is provided galvanically isolated from the fuse receiving device. In a further step the galvanically isolated output signal is received by the monitoring unit included in the load-break switching device.

The present invention is based on the finding that load-break switching devices usually require a relatively large assembly volume, and minimising the assembly volume makes it difficult to have access to the elements of the load-break switching device. Thus, if the load-switching device comprises one or more fuses, minimising the assembly volume makes it difficult for a user to reach the compartment of the fuse in order to determine whether a fuse is inserted and in good order.

The present invention therefore takes into account this finding and aims to provide an improved load-break switching device. In particular, the present invention aims to provide a load-break switching device which can be realised with reduced assembly volume and which can provide a reliable signalling in case that a fuse of the load-break switching devices is not inserted or the fuse already has been triggered.

The concept according to the present invention makes it possible to indicate a faulty condition, i.e. a missing or faulty fuse, in a very simple way. Hence, only a few additional components are required. This makes it possible to realise the inventive concept by a very small assembly volume and with low costs.

Further to this, the signalling provided by the proposed approach is provided by a galvanically isolated signal. In other words, the contacts of the fuse are galvanically isolated from the signalling output of the electronic unit. In this way, the provided signalling of the abnormal condition can be received by a further component without additional security measures. Further to this, the galvanic isolation also improves the robustness and reliability of the provided signalling.

The busbar system may comprise one or more busbars. For example, in case of an AC application with a single phase, the busbar system may comprise only a single busbar. Alternatively, for applications with multiple phases, the busbar system may comprise more than one busbar. For example, the busbar system may comprise three busbars (L1, L2, L3) for a three-phased AC system. However, the busbar system may be also a busbar system for a DC application. In this case, the busbar system may comprise, for example, two busbars (a positive busbar and negative busbar). However, the present invention is not limited to the above-mentioned examples. Moreover, any other number of busbars may be possible, too.

The load-break switch switching device may be electrically coupled with the busbars of the busbar system by a first connector unit. For this purpose, a separate connection element (first connection terminal) may be provided in the first connector unit for each busbar to be connected. The connection elements may be configured in such a manner that a reliable electrical connection can be established when connecting the terminals of the first connector unit to the busbars of the busbar system. For example, the first connection terminals may comprise springs or the like in order to provide an appropriate force towards the busbars. However, any other appropriate measure for a reliable electrical connection may be possible, too.

For each first connection terminal of the first connector unit, a corresponding second connection terminal of the second connector unit may be provided. For example, an electrical device such as a load, in particular a motor or the like, may be electrically connected to the second connector unit of the load-break switching device. For this purpose, wires may be connected to the second connection terminals of the second connector unit by means of clamp connections or screw connections. The electrical connection at the second connector unit can be established in any other way, too.

The load-break unit of the load-break switching device is electrically arranged between the first connector unit and the second connector unit. In this way, the load-break unit can establish an electrical connection between the first connection terminals of the first connector unit and the corresponding second connection terminals, if the respective switching elements of the load-break unit are closed. Alternatively, the electrical connection between the first connection terminals and the corresponding second connection terminals is interrupted, if the respective switching elements of the load-break unit are opened. In particular, the load-break unit can even interrupt the electrical connection if a current is flowing through the load-break unit.

However, since such an interruption of a flowing current usually is limited to a maximum switching current, the load-break unit may further comprise fuses for overcurrent protection. The fuses may trigger, if a current through the fuse (and consequently through the load-break switching device) exceeds a predetermined value. The fuses may be any kind of appropriate overcurrent fuse, in particular non-reversal fuses. Thus, such a fuse has to be replaced after the fuse has been triggered.

The fuses may have, for example, a cylindric shape. for example, the fuses may be, DO-fuses, D01, class CC or 10x38 fuses or other appropriate fuses for overcurrent protection. Particularly, the fuses may be low voltage fuses rated for voltages up to IkV. For example, the fuses may provide overcurrent protection in a range of 16A, 32A, 50A, 100A. However, any other appropriate range depending on the desired application and the properties of the load-break unit may be possible, too.

Each fuse unit for a current path between a first connection terminal of the first connector unit and a corresponding second connection terminal of the second connector unit comprises a fuse receiving element. The fuse receiving element may provide an appropriate compartment for receiving the fuse and for connecting the fuse with related fuse terminals. For example, a first terminal of the fuse may be connected by a first fuse connector of the fuse receiving device, and a second terminal of the fuse may be connected by a second fuse connector of the fuse receiving device. Thus, after inserting a proper fuse in the fuse receiving element, an electrical connection between the first fuse connector and the second fuse connector is established by the fuse.

However, if the fuse has been triggered or if no fuse is inserted in the fuse receiving element, the connection between the first fuse connector and the second fuse connector is interrupted, and thus, the electrical connection between the first connection terminal of the first connector unit and the corresponding second connection terminal of the second connector unit is interrupted, too. Such a faulty condition, i.e. when the electrical connection between the first fuse corrector and the second fuse connector is interrupted, can be detected by the electronic unit of the respective fuse unit.

For this purpose, the electrical unit is electrically connected to the first fuse connector and the second fuse connector, respectively. Accordingly, the electrical unit analyses a voltage drop (voltage difference) between the first fuse connector and the second fuse connector. In case of a proper fuse, there is only a very low voltage drop over the fuse. However, if the fuse has been triggered or if no fuse is inserted, the voltage between the first fuse connector and the second fuse connector may be higher. Thus, if the voltage drop exceeds a predetermined threshold value, the electronic unit may detect an abnormal condition for the respective fuse unit. Such a detected abnormal condition may be indicated by providing an appropriate signalling. For example, the abnormal condition could be indicated by changing a state of the signal, e.g. from low to high or vice versa. However, any other appropriate signalling may be possible, too. In particular, the provided signalling of the electronic unit may be provided by a signal which is galvanically insulated from the potential of the fuse terminals. For this purpose, the electronic unit may comprise an appropriate element for providing galvanic insulation.

In a possible embodiment, each electronic unit comprises an optocoupler. The optocoupler may be used for providing the galvanically isolated output signal. In this way, a very simple and cheap solution for providing the galvanically insulated signalling can be achieved. For example, a LED of the optocoupler may be activated directly or indirectly based on the voltage drop between the first fuse terminal and the second fuse terminal.

In a possible embodiment, the optocoupler is operated using invisible light. In particular the optocoupler may be operated by infrared light. In this way, disturbances due to the impact of visible light it can be avoided or at least minimised.

In a possible embodiment, the at least one electronic unit is powered by the voltage drop between the first connector and the second fuse connector of the fuse receiving device. Thus, no additional power source is required in order to provide the signalling of the fuse status.

In a possible embodiment, each first connection terminal of the first connection unit is adapted to be connected to at least one busbar of a busbar system. Thus, the load-break switching device may be used for coupling the external electric device to a busbar system.

In a possible embodiment, the monitoring unit comprises a communication interface. The communication interface may be adapted to establish a communication link with a remote device. The communication interface may be further configured to output a message to the remote device. In particular, the communication interface may output a message if an output signalling has been received from at least one of the electronic units. The communication interface may be, for example, a communication interface such as Modbus/RTU, Modbus/TCP/IP, CAN-bus, IO-Link or any other appropriate communication standard. The communication interface may also use, for example, power LAN technologies, such as power line. In this way, the communication can be performed, for example via the powerlines connected to the first connector unit and/or the second connector unit, or via a (DC) power supply of the monitoring unit and/or other auxiliary devices of the load-break switching device. Additionally or alternatively, it may be also possible to perform a wireless communication. For example, the communication interface may use WLAN, Bluetooth, NFC, Zigbee or any other known or upcoming communication standard.

In a possible embodiment, each electronic unit comprises sensor element. The sensor elements may be adapted to sense a physical property of the fuse. The electronic unit may be adapted to provide the output signal based on the physical property sensed by the sensor element. For example, the signalling of the electronic unit may be further modulated in an appropriate manner in order to transmit further information such as the value of the sensed physical property.

In a possible embodiment, the sensor element comprises a thermal sensor. In this way, information of the temperature of the fuse may be provided. This information may be used, for example, in order to detect an (abnormal) change of the temperature of the fuse. This may indicate, for example, that the fuse is about to trigger. However, the sensor element may also comprise any other appropriate sensor. For example, the sensor element may comprise an acoustic sensor. Such acoustic sensor may detect noise which occurs in the event when the fuse triggers. Thus, additional information with regard to a possible triggering of the fuse may be provided.

In a possible embodiment, each fuse unit comprises a signalling unit. The signalling unit may be adapted to provide an optical, acoustic and/or haptic signalling to a user. In particular, the signalling of the signalling unit may indicate whether an abnormal condition is detected by the respective electronic unit of the fuse unit. In this way, the user can be provided with additional information in order easily detect the fuse unit of the abnormal condition. the optical signalling may comprise, for example, a light such as an LED, which is switched on if an abnormal condition is detected. Alternatively, a colour of the light may change or the light may flash with a predetermined frequency. The acoustic signalling may be, for example, the sound such as a beep or the like. A haptic signalling may be, for example, a pin which is moved to a particular position in case of a detected abnormal condition.

In a possible embodiment, the load-break unit is arranged in a current path between the first connector unit and the fuse unit. A further load-break unit may be arranged in a current path between the fuse unit and the second connector unit. In this way, both terminals of the fuse unit can be electrically separated by one of the two load-break unit. The two load-break units may be switched synchronously, i.e. both load-break unit may be opened and closed at the same time. Alternatively, the two load-break unit may be switched individually.

In a possible embodiment, the load-break unit is adapted to interrupt electrical connections between the first connection terminals of the first connector unit and the corresponding second connection terminals of the second connector unit on load. In other words, the load-break unit can interrupt the electrical connection between the first connection terminals of the first connector unit and the related second connection terminals of the second connector unit even if a current is flowing through the load-break unit. This makes it possible, for example, to switch even loads with high inductance or capacitance such as, for example, electrical motors. In particular, the load-break units may switch loads up to AC-23B according to IEC 60947-3.

In a possible embodiment the load-break switch has an outer width of at most about 27 millimetres, in particular at most about 22,4 millimetres. Accordingly, the load-break switching device is realised with a very small size and assembly volume. In particular, the load-break switching devices with such dimensions as appropriate to provide the required distances with respect to the leakage current demands as required, for example according to the pending UL norms.

In a possible embodiment, the fuse receiving device is adapted to receive a low-voltage fuse having a maximum rated voltage up to 1000 volts. The fuses may be, for example, any appropriate fuse according to the UL or IEC domain. The fuses may be, for example, NH fuses (NH000 up to NH 3), UL (Class) fuses, Class CF fuses or psychological fuses such as D0, D012, D02, 22x58 10x85, 14x51, etc.. The fuses may have a cylindrical shape which fits to the compartment of the fuse receiving element.

In the following, possible embodiments of the different aspects of the present invention are described in more detail with reference to the enclosed figures.
- Fig. 1:: a schematic diagram of load-break switching device according to an embodiment;
- Fig. 2:: a schematic diagram of a fuse unit for a load-break switching device according to an embodiment;
- Fig. 3:: a schematic diagram of a fuse unit for a load-break switching device according to another embodiment;
- Fig. 4:: a schematic illustration of a load-break switching device in a switching cabinet arrangement according to an embodiment; and
- Fig. 5:: a flow diagram illustrating a method for operating a load-break switching device according to an embodiment.

### Description of embodiments

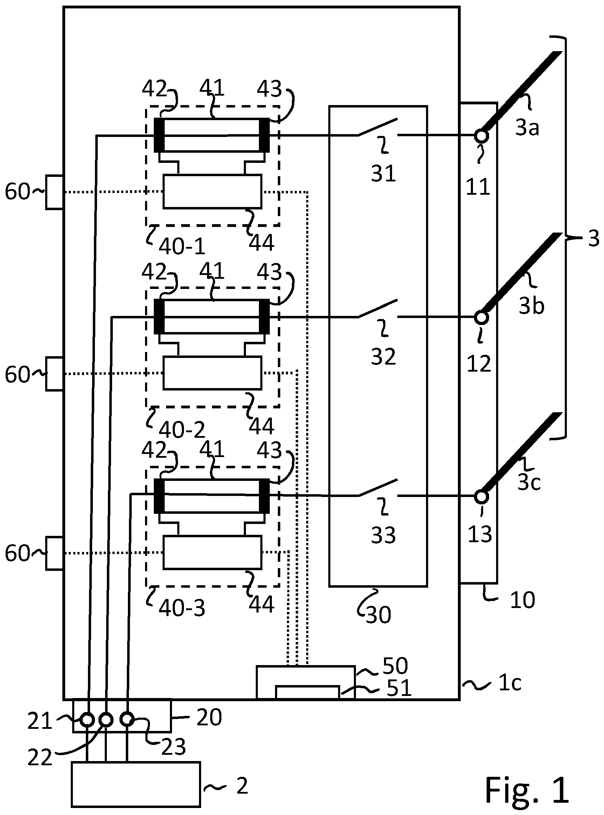

Figure 1 shows a schematic block diagram illustrating a load-break switching device 1 according to an embodiment. The load-break switching device 1 may comprise a first connector unit 10 and a second connector unit 20. Further, the load-break switching device 1 may comprise a load-break unit 30 and one or more fuse units 40-i.

The load-break switching device 1 may be electrically (and mechanically) connected to a busbar system 3. For this purpose, the first connector unit 10 may comprise one or more first connection terminals 11, 12, 13. Each first collection terminal 11, 12, 13 may be connected to a respective busbar 3a, 3b, 3c of the busbar system 3. For this purpose, the first connection terminals 11, 12, 13 may comprise appropriate connection elements for a reliable connection with the corresponding busbar 3a, 3b, 3c. For example, the first connection terminals 11, 12, 13 may have a shape which fits to corresponding elements of the busbars 3a, 3b, 3c.

Even though the present invention is described here and in the following embodiments in connection with a busbar system 3 comprising three busbars 3a, 3b, 3c, it is emphasised that the present invention is not limited to a busbar system comprising three busbars. Moreover, any other appropriate number of busbars, in particular one busbar, two busbars or more than three busbars may be possible, too. For example, the present invention may be also applicable to AC applications with only a single phase requiring only a single busbar. Furthermore, it may be also possible to apply the present invention to DC applications.

In another configuration, the load-break switching device 1 may be connected at the first connector unit 10 in any other way instead of using a busbar system 3. For example, the load-break switching device 1 may be directly mounted on a on a mounting plate or a top-hat rail. In such a configuration, the first connection terminals 11, 12, 13 of the first connector unit 10 may be coupled with corresponding wires 3a, 3b, 3c of an electrical system 3.

The second connector unit 20 may comprise one or more second connection terminals 21, 22, 23. In particular, the number of second connection terminals corresponds to the number of first connection terminals 11, 12, 13. Each second connection terminal 21, 22, 23 may be connected to an external electrical device 2. For this purpose, each second connection terminal 21, 22, 23 may receive a wire for connecting the respective terminal 21, 22, 23 with the external electrical device 2. For example, the second connection terminals 21, 22, 23 may comprise a clamping mechanism or any other appropriate component for receiving and fastening the wires. In this way, it is possible to electrically connect the busbars 3a, 3b, 3c via the internal structure of the load-break switching device 1 with the external electrical device 2.

The external electrical devices 2 may be any kind of appropriate electrical device. For example, the electrical device 2 may be an electrical load, e.g., a motor, an actor of an automation system or any other component requiring electrical power. However, the external electrical device 2 may be also a power source, e.g., an inverter of a photovoltaic system or any other device providing electrical power. In this way, electrical power of the external electrical device 2 may be provided to the busbar system 3.

The load-break switch device 1 comprises a load-break unit 30 which can establish or interrupt the electrical connection between the first connection terminals 11, 12, 13 and the corresponding second connection terminals 21, 22, 23. For this purpose, load-break unit 30 may comprise a number of switching element 31, 32, 33. In particular, a separate switching element 31, 32, 33 is provided for each current path between a first connection terminal 11, 12, 13 and the corresponding second connection terminal 21, 22, 23. The operation of the individual switching elements 31, 32, 33 may be controlled by a common, single mechanism. Accordingly, the switching elements 31, 32, 33 are all either in a closed state or in an open state. The switching elements 31, 32, 33 may be switching elements which can interrupt the connection between the first connecting terminals 11, 12, 13 and the second connecting terminals 21, 22, 23 even if a current is flowing through the switching element 31, 32, 33. In other words, the switching element 31, 32, 33 can be opened on load.

Further, a fuse unit 40-i is arranged in each current path between the first connection terminals 11, 12, 13 and the second connection terminals 21, 22, 23. In particular, the fuse units 40-i are arranged between the switching elements 31, 32, 33 of the load-break unit 30 and the second connection terminals 21, 22, 23 of the second connector unit 20. Each fuse unit 40-i comprises a fuse receiving element 41 for receiving a fuse. In particular, the fuse receiving element 41 may comprise a first fuse connector 42 and a second fuse connector 43, wherein a first terminal of a fuse 45 may be connected to the first fuse connector 42 and a second terminal of the fuse 45 may be connected to the second fuse connecter 43.

In this way, the fuse 45 may electrically connect the first fuse connector 42 with the second fuse connector 43. Concluding, the load-break switching device 1 provides one or more current paths from a first connection terminals 11, 12, 13 of the first connector unit 10 via the switching elements 31, 30 to 33 of the load-break unit 30 and the fuses 45 of the fuse units 40-i to the related second connection terminals 21, 22, 23 of the second connector unit 20. By operating a switching element 31, 32, 33 of the load-break unit 13, the electrical connections between the first connection terminals 11, 12, 13 and the corresponding second connection terminals 21, 22, 23 can it be established or interrupted.

Since the above-mentioned connections between the first connection terminals 11, 12, 13 and the second connection terminals 21, 22, 23 can only established if the fuses 45 in the fuse units 40-i are inserted and in good condition (i.e., conducting), it is of great importance to detect a missing fuse 45 or a fuse which has been triggered. For this purpose, each load-break unit 40-i may comprise an electronic unit 44. The electronic units 44 may detect an abnormal condition such as a missing fuse 45 or a fuse 45 which does not provide conducting properties (e.g., because the fuse has been triggered). If such an abnormal condition is detected by the electronic unit 44, the respective electronic unit 44 may provide a signalling for indicating the abnormal condition. The provided signalling for the abnormal condition may be provided by a signal which is galvanically insulated from the potential of the fuse connectors 42, 43. The detailed structure and operation of the electronic unit 44 will be described in more detail below.

The signalling of the abnormal condition from the electronic units 44 may be provided to a monitoring unit 50 of the load-break switching device 1. Monitoring unit 50 may receive the signalling from the electronic units 44 and perform an appropriate controlling of the load-break switching device 1. Further to this, monitoring unit 50 may transmit an appropriate message to a further device, for example a remote device. For this purpose, monitoring unit 50 may comprise a communication interface 51. Accordingly, a message or notification may be transmitted from the monitoring unit 50 to a remote device.

Communication may be performed, for example, based on any appropriate communication standard, for example Modbus RTP, Modbus TCP/IP, CAN bus, IO link, etc. However, any other standard or proprietary communication schema may be used, too. The communication of the communication interface 51 may also use, for example, power LAN technologies, such as power line. Thus, the communication may be performed, for example via the powerlines connected to the first connector unit 10 and/or the second connector unit 20, or via a (DC) power supply of the monitoring unit 50 and/or other auxiliary devices of the load-break switching device 1. Additionally or alternatively, it may be also possible to perform a wireless communication. For example, the communication interface 51 may use WLAN, Bluetooth, NFC, Zigbee or any other known or upcoming communication standard.

In this way, the notification of the abnormal condition in the load-break switching device 1 can be received by the remote device, and a user at the remote device may be notified, or any kind of automated operation may be applied in response to the detection of the abnormal condition in a fuse unit 40 of the load-break switching device 1.

Optionally, load-break switching device 1 may comprise a signalling unit 60. The signalling unit 60 may provide a signalling to a local user. In particular, a signalling to the local user may be provided if an abnormal condition, in particular in interrupted or missing fuse 45 is detected. The signalling may be, for example, an optical signalling such as an indicator light, especially an LED. The indicator light may be a continuous light, a flashing light, a light which changes in colour when detecting an abnormal condition or any other kind of optical indication.

The signalling may be also an acoustic signalling such as a beep and/or a haptic indication such as a pin which protrudes after detecting an abnormal condition. Any other kind of local indication may be possible, too. In this way, the user can easily identify the load-break switching device 1 with an abnormal condition. Furthermore, the indication may guide the user in order to identify the fuse unit 40-i with the detected abnormal condition. Hence, the maintenance procedure for replacing or inserting a new fuse 45 can be simplified and accelerated.

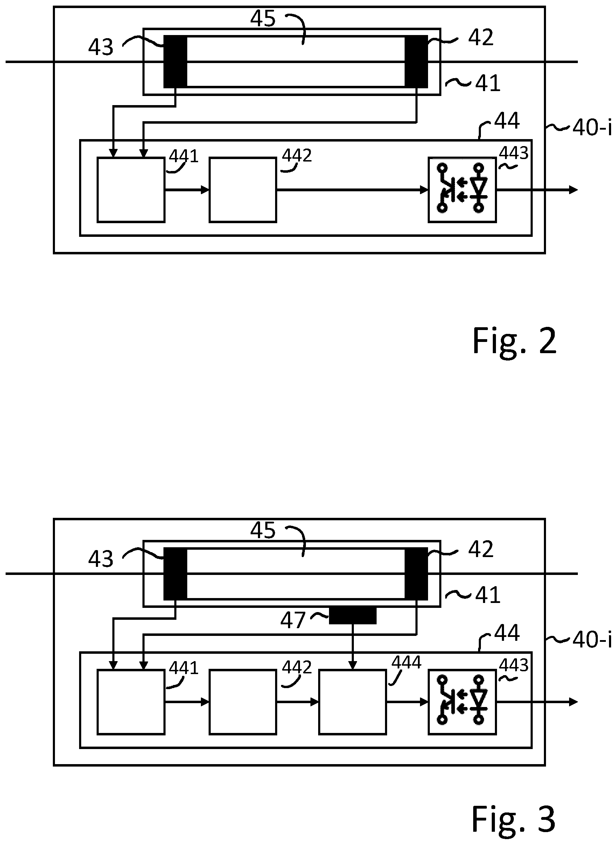

Figure 2 shows a schematic illustration of a fuse unit 40-i according to an embodiment. The fuse unit 40-i may be a fuse unit 40-i of the load-break switching device 1 as already described above in connection with figure 1.

As can be seen in more detail in figure 2, the first fuse connector 42 and the second fuse connector 43 of fuse receiving element 41 are electrically connected to the electronic unit 44. In this way, electronic unit 44 can determine a voltage drop between the first fuse connector 42 and the second fuse connector 43. If a fuse 45 is correctly inserted in the fuse receiving element 41 and the fuse 45 is in good condition, i.e., the fuse 45 has conducting properties, the voltage drop between the first fuse connector 42 and the second fuse connector 43 is very low. For example, the voltage drop may be less than one Volt, e.g. some Millivolts. However, if no fuse 45 is provided in the fuse receiving element 41, or the fuse 45 has been already triggered so that the fuse 45 does no longer provide conducting properties between the terminals of the fuse 45, the voltage drop between the first fuse connector 42 and the second fuse connector 43 may be higher. In particular, a significant voltage drop between the first fuse connector 42 and the second fuse connector 43 will occur, if the switching elements 31, 32 and 33 of the load-break unit 30 are closed and thus, a voltage is applied to the fuse units 40-i.

Based on the detected voltage drop between the first fuse connector 42 and the second fuse connector 43, electronic unit 44 can identify an abnormal condition in the respective fuse unit 40. In particular, an abnormal condition, e.g. due to a missing or triggered fuse 45, may be detected by electronic unit 44 if the voltage drop between the first fuse connector 42 and the second fuse connector 43 exceeds a predetermined threshold value.

Figure 2 further illustrates an exemplary possible structure for implementing the electronic unit 44. Electronic unit 44 may comprise a measurement component 441. The measurement component 441 may electrically connected to the first fuse connector 42 and to the second fuse connector 43. Accordingly, measurement component 441 may measure a voltage difference of the voltage drop between the first fuse connector 42 and the second fuse connector 43. In case of AC applications, measurement component 441 may comprise a rectifying element, e.g., at least one diode. Further, measurement component 441 may comprise a holding element such as a capacitor. Accordingly, a robust detection of the voltage drop between the first fuse connector 42 and the second fuse connector 43 can be achieved.

Instead of sensing the voltage drop directly at the fuse receiving element 41, the measurement component 441 may also sense a voltage drop at another position of the current path between the second connector unit 20 and the load-break unit 30 or in a current path between the first connector unit 10 and the load-break unit 30. In some cases, this may require an additional logic if, for example, the voltage is sensed in the current path facing away from the load-break unit 30, as a voltage drop may occurs at such positions even if the load-break unit 30 is switched off. However, an appropriate logic may be applied for such use cases.

Electronic unit 44 may further comprise a detection component 442. Detection component 442 may change its output state, if the detected voltage drop from measurement component 441 exceeds a predetermined threshold value. For example, detection component may comprise an element such as a Zener diode or any other appropriate element for detecting whether a voltage exceeds a predetermined threshold value. Accordingly, an output of detection component 442 may change if the voltage drop detected by measurement component 441 exceeds the predetermined threshold value.

The output of detection component 442 may be provided to an insulating component 443. For example, this insulating component 443 may be an optocoupler. The output signal from detection component 442 may drive a light emitting element, e.g., an LED, in particular an infrared LED. The light of this light emitting element may be provided to a receiving element which may change its state depending on whether or not light is received by the receiving element. In this way, insulating component 443 provides a galvanically insulated signalling of the result for detecting an abnormal condition in the fuse unit 40-i. However, any other appropriate scheme for outputting a galvanically insulated signalling based on a voltage drop between the first and second fuse connectors 42, 43 may be possible, too.

Since the configuration of electronic unit 41 can be realised by only a few very simple components, electronic unit 41 requires only very small assembly space. Further to this, electronic unit 44 may be powered only based on electrical power obtained from the voltage drop between the first and second fuse connectors 42, 43. Thus, no external power supply might be required.

Figure 3 shows a schematic illustration of a fuse unit 40-i according to a further embodiment. Since the configuration of the fuse unit 40-i mainly is based on the configuration of the fuse unit 40-i which has been already described above in connection with figure 2, the above provided explanation also applies to the embodiment of figure 3.

The fuse unit 40-i in figure 3 further comprises at least one sensor element 47. For example, sensor element 47 may be a thermal sensor. Such a thermal sensor may sense a temperature of fuse 45 or the environment of fuse 45. If the temperature of fuse 45 increases, this might be a precursor for an upcoming triggering of fuse 45.

Additionally, or alternatively, the sensor element 47 may be a sensor element for detecting noise. Since a triggering of fuse 45 usually may be related with a specific noise event, such a triggering of fuse 45 may be also detected by sensing noise in the environment of fuse 45. However, any other appropriate sensor element 47 for detecting a physical property may be possible, too.

If at least one sensor element 47 sensed a physical property of fuse 45 or the environment of fuse 45, the result of this sensing may be also transmitted via the insulating component 443. For example, electronic unit 44 may comprise a modulating component 444. This modulating component 444 may modulate the signal from sensor element 47 and combine the modulated signal with the output of detection component 442. In this way, the insulating component 443 may provide an output signal comprising not only the detection of an abnormal condition but also the information from the sensor element 47.

In the above examples, the fuse units 40-i are provided between the load-break unit 30 and the second connection unit 20, whereas the load-break unit 30 is connected to the first connection unit 10. In general, however, other configurations are possible in which the fuse units 40-i are connected to the first connection unit 10 and the load-break unit 30 is connected to the second connection unit 20. In this case, the above explanations apply accordingly, whereby the skilled person will make appropriate configuration adjustments where necessary.

In a further alternative embodiment, the load-break switching device 1 may comprise two load-break units 30. In such a configuration, a first load-break unit 30 may be arranged between the first connection unit 10 and the fuse units 40-i. A further, second load-break unit 30 may be arranged between the fuse units 40-i and the second connection unit 20. For example, the first and the second load-break unit 30 may be switched synchronously, i.e. both load-break unit 30 are switched on or off at the same time. However, it may be also possible to switch the first load-break unit 30 and the second load-break unit 30 independently from each other.

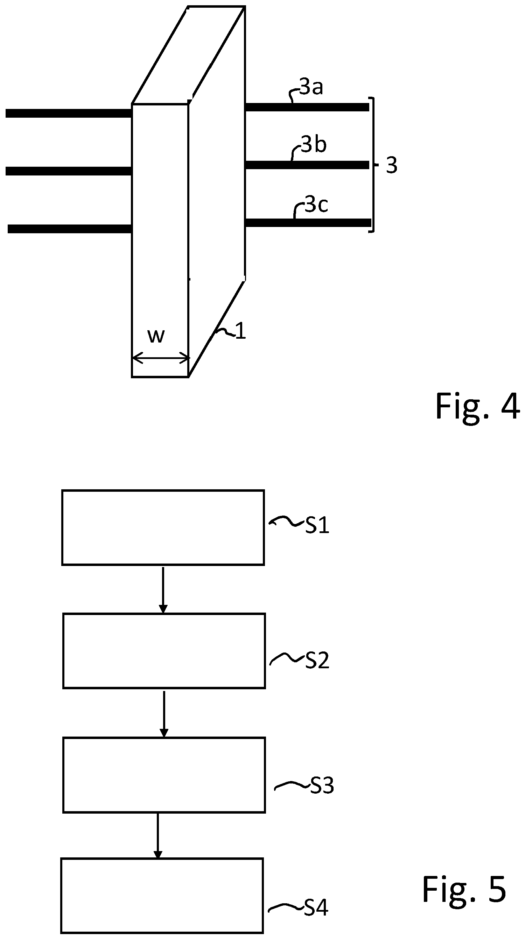

The load-break switching device 1 may be installed, for example, in a switching cabinet with a busbar system 3. Such a configuration is illustrated, for example, in figure 4. For instance, such a configuration may be used in an automation system. In particular, the load-break switching device 1 may be used for supplying power to a load 2. The load 2 connected to the load-break switching device 1 may be, for example, a resistive, inductive or capacitive load. For instance, load to may be an electrical motor or the like. However, any other load, such as an actor of an automation system or the like may be possible, too.

As can be further seen in figure 4, load-break switching device 1 may comprise a housing including the above-described components. In particular, the housing of load-break switching device 1 may have a relatively small width w. For example, width w of the housing may be27 mm) or less. In particular, width w of the housing may be only 22,5. This makes it possible to realize small-sized devices and fulfil the requirements for the required distances with respect to the leakage current demands as required, for example according to the pending UL norms or other standards. However, depending on the further constraints of the application, any other dimensions may be possible, too.

Figure 5 shows a flow diagram illustrating a method for operating a load-break switching device 1 according to an embodiment. The method may be applied to the above-described load-break switching device 1. Hence, the method may comprise any step for performing operations as already described above in connection with the load-break switching device 1. Further, the above-described load-break switching device 1 may comprise any kind of device, unit or component for performing operations as described in the following in connection with the method.

The method comprises a step S1 of sensing a voltage drop between the first fuse connector 42 and the second fuse connector 43 of the fuse receiving device 41. If the load-break switching device 1 is used in connection with AC applications, the sensed voltage drop may be rectified. Further, the voltage drop may be filtered or smoothed.

The method further comprises a step S2 of detecting an abnormal condition of the related fuse receiving device 41. In particular, the abnormal condition is detected if the detected voltage drop exceeds a predetermined threshold value.

The method further comprises a step S3 of providing an output signal. The output signal indicates the detected abnormal condition. In particular, the output signal is provided galvanically isolated from the fuse receiving device.

The method further comprises a step S4 of receiving the galvanically isolated output signal by the monitoring unit 50 which is included in the load-break switching device.

Summarising, the present invention relates to a small-sized (low-width) load-break switching device for a busbar system. The load-break switching device comprises fuse receiving compartments for fuses. A simple and small sized approach for detecting a failure of the fuse in the receiving compartments is provided. A failure of the fuse is indicated by a galvanic insulated signalling.

## Claims

1. Load-break switching device (1), comprising
a first connector unit (10) comprising at least one first terminal (11, 12, 13), each first connection terminal (11, 12, 13) is adapted to be connected to a power source or load (3);
a second connector unit (20) comprising at least one second terminal (21, 22, 23), each second connection terminal (21, 22, 23) is adapted to be connected to an electrical connection of an external electrical device (2);
a load-break unit (30), adapted to interrupt electrical connections between the first connection terminals (11, 12, 13) of the first connector unit (10) and the corresponding second connection terminals (21, 22, 23) of the second connector unit (20);
at least one fuse unit (40-i), each of the at least one fuse unit (40-i) disposed in a current path between one of the first connection terminals (11, 12, 13) of the first connector unit (10) and a corresponding second connection terminal (21, 22, 23) of the second connector unit (20),
wherein each fuse unit (40-i) comprises a fuse receiving element (41) and an electronic unit (44),
each fuse receiving element (41) is adapted to receive a fuse (45) between a first fuse connector (42) and a second fuse connector (43), and
each electronic unit (44) is adapted to sense a voltage drop in a current path between the first connector unit (10) and the second connector unit (20), the current path including the fuse receiving device (41), to detect an abnormal condition of the related fuse unit (40-i) if the detected voltage drop exceeds a predetermined threshold value, and to provide an output signal indicating the detected abnormal condition, wherein the output signal is galvanically isolated from the fuse receiving element;
wherein the load-break switching device (1) further comprises a monitoring unit (50) adapted to receive the output signal of the at least one electronic unit (40).

2. Load-break switching device (1) according to claim 1, wherein each electronic unit (44) comprises an optocoupler for providing the galvanically isolated output signal.

3. Load-break switching device (1) according to claim 2, wherein the optocoupler is operating using invisible light, in particular infrared light.

4. Load-break switching device (1) according to any of claims 1 to 3, wherein the at least one electronic unit (44) is powered by the voltage drop between the first fuse connector (42) and the second fuse connector (43) of the fuse receiving device (41).

5. Load-break switching device (1) according to any of claims 1 to 4, wherein each first connection terminal (11, 12, 13) of the first connection unit (10) is adapted to be connected to at least one busbar (3a, 3b, 3c) of a busbar system (3)

6. Load-break switching device (1) according to any of claims 1 to 5, wherein the monitoring unit (50) comprises a communication interface (51) adapted to establish a communication link with a remote device, and to output a message to the remote device when an output signalling has been received from one of the at least one electronic units.

7. Load-break switching device (1) according to any of claims 1 to 6, wherein each electronic unit (44) comprises sensor element (47) adapted to sense a physical property of the fuse in the fuse unit, and wherein the electronic unit (44) is adapted to provide the output signal based on the physical property sensed by the sensor element (47).

8. Load-break switching device (1) according to claim 7, wherein the sensor element (47) comprises a thermal sensor.

9. Load-break switching device (1) according to any of claims 1 to 8, wherein each fuse unit (40-i) comprises a signalling unit (60), adapted to provide an optical, acoustic and/or haptic signalling to a user, if an abnormal condition is detected by the respective electronic unit (44) of the fuse unit (40-i).

10. Load-break switching device (1) according to any of claims 1 to 9, wherein the load-break unit (30) is arranged in a current path between the first connector unit (10) and the fuse unit (40-i), and a further load-break unit is arranged in a current path between the fuse unit (40-i) and the second connector unit (20).

11. Load-break switching device (1) according to any of claims 1 to 10, wherein the load-break switch device (1) has an outer width (w) of at most 27 millimetres, in particular at most 225 millimetres.

12. Load-break switching device (1) according to any of claims 1 to 11, wherein the fuse receiving device (41) is adapted to receive a low-voltage fuse having a maximum rated voltage up to 1000 volts.

13. Switching cabinet arrangement comprising:
a load-break switching device (1) according to any of claims 1 to 12; and
a busbar system (3) comprising at least one busbar (3a, 3b, 3c), wherein the at least busbar (3a, 3b, 3c) is electrically connected to the first connector unit (10) of the load-break switching device (1) .

14. Automation system, comprising:
a load-break switching device (1) according to any of claims 1 to 12; and
a busbar system (3) comprising at least one busbar (3a, 3b, 3c), wherein the at least busbar (3a, 3b, 3c) is electrically connected to the first connector unit (10) of the load-break switching device (1); and
an electric device (2), electrically connected to the second connector unit (20) of the load-break switching device (1).

15. Method for operating load-break switching device (1) according to any of claims 1 to 12, comprising the steps of:
sensing (S1) a voltage drop in a current path between the first connector unit (10) and the second connector unit (20), the current path including the fuse receiving device (41);
detecting (S2) an abnormal condition of the related fuse device (40-i), if the detected voltage drop exceeds a predetermined threshold value; and
providing (S3) an output signal indicating the detected abnormal condition, wherein the output signal is provided galvanically isolated from the fuse receiving device; and
receiving (S4) the galvanically isolated output signal by the monitoring unit (50) included in the load-break switching device (1) .
